# EUROPEAN PATENT APPLICATION

(11) **EP 4 379 776 A1**
(43) Date of publication of application: **05.06.2024**
(21) Application number: 22853102.6
(22) Date of filing: 03.08.2022
(51) Int. Cl.: H01L 21/304

(54) **POLISHING LIQUID FOR CMP, POLISHING LIQUID SET FOR CMP AND POLISHING METHOD**

(30) Priority: 06.08.2021 WO PCT/JP2021/029409
(71) Applicant: Resonac Corporation, Tokyo 105-7325 (JP)
(72) Inventor: KURATA, Yasushi, Minato-ku, Tokyo 105-7325 (JP); IWANO, Tomohiro, Minato-ku, Tokyo 105-7325 (JP); MURAKAMI, Noriaki, Minato-ku, Tokyo 105-7325 (JP); MIZUTANI, Makoto, Minato-ku, Tokyo 105-7325 (JP); KUBOTA, Shigeki, Minato-ku, Tokyo 105-7325 (JP); ONUMA, Taira, Minato-ku, Tokyo 105-7325 (JP); KANNO, Masahiro, Minato-ku, Tokyo 105-7325 (JP)
(74) Representative: Hoffmann Eitle
(86) International application number: PCT/JP2022/029820
(87) International publication number: WO 2023/013683

(57) **Abstract**

A polishing liquid for CMP, containing: abrasive grains; an additive; and water, in which the abrasive grains include cerium-based particles, the additive includes (A1) a 4-pyrone-based compound represented by General Formula (1) below and (B) a compound having two or more nitrogen atoms to which a hydroxyalkyl group is bonded. A polishing liquid for CMP, containing: abrasive grains; an additive; and water, in which the abrasive grains include cerium-based particles, the additive includes (A2) picolinic acid and (B) a compound having two or more nitrogen atoms to which a hydroxyalkyl group is bonded. 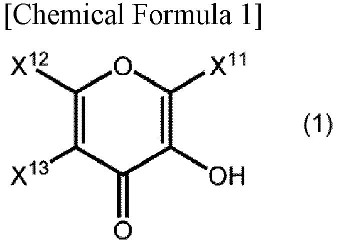 [in the formula, X¹¹, X¹², and X¹³ are each independently a hydrogen atom or a monovalent substituent.]

## Description

### Technical Field

The present disclosure relates to a polishing liquid for CMP (chemical mechanical polishing), a polishing liquid set for CMP, a polishing method, and the like.

### Background Art

In the field of semiconductor production, with achievement of high performance of ultra LSI devices, a miniaturization technology as an extension of the conventional technology finds restriction in allowing high integration and speed-up to be compatible with each other. Accordingly, techniques for allowing vertical high integration (namely, techniques for developing multilayered wiring) while miniaturization of semiconductor elements have been developed.

In the process for producing a device including multilayered wiring, one of the most important techniques is a CMP technique. The CMP technique is a technique that flattens a surface of a base substrate obtained by forming a thin film on a substrate by chemical vapor deposition (CVD) or the like. For example, a flattening treatment by CMP is essential to ensure the depth of focus in lithography. When the surface of the base substrate has irregularities, there occur, for example, such troubles that the focusing in an exposure step is precluded, and a fine wiring structure cannot be sufficiently formed. Furthermore, the CMP technique is also applied to the step of forming element isolation (isolation between elements; STI: shallow trench isolation) regions by polishing of plasma oxide films (such as BPSG, HDP-SiO₂, and p-TEOS); the step of forming an ILD film (interlayer insulating film; an insulating film electrically insulating metal members (wirings and the like) in the same layer); the step of flattening plugs (for example, Al or Cu plugs) after embedding a film containing silicon oxide in a metal wiring; and the like in device manufacturing process.

CMP is usually performed using an apparatus capable of supplying a polishing liquid onto a polishing pad. Further, the surface of a base substrate is polished by pressing the base substrate against the polishing pad while a polishing liquid is supplied between the surface of the base substrate and the polishing pad. As described above, in the CMP technique, a polishing liquid is one of elemental technologies, and various polishing liquids have also been hitherto developed in order to obtain a high-performance polishing liquid (see, for example, Patent Literature 1 below).

Among the steps to which the CMP technique as mentioned above is applied, particularly, in the CMP step for the ILD film, it is necessary to polish silicon oxide at a high polishing rate. Therefore, in the CMP step for the ILD film, a silica-based polishing liquid (a polishing liquid using abrasive grains including silica-based particles) having a high polishing rate is mainly used (see, for example, Patent Literature 2 below). However, in the silica-based polishing liquid, it tends to be difficult to control polishing scratches which cause defects. Furthermore, with the recent miniaturization of wirings, it is desirable to reduce polishing scratches in the CMP step for the ILD film, but unlike the CMP step for an insulating film for an element isolation region, final mirror polishing is generally not performed. Therefore, the use of a cerium-based polishing liquid (a polishing liquid using abrasive grains including cerium-based particles), which causes fewer polishing scratches than the silica-based polishing liquid, is being studied (see, for example, Patent Literature 3 below).

### Citation List

### Patent Literature

Patent Literature 1: Japanese Unexamined Patent Publication No. 2008-288537
Patent Literature 2: Japanese Unexamined Patent Publication No. H9-316431
Patent Literature 3: Japanese Unexamined Patent Publication No. H10-102038

### Summary of Invention

### Technical Problem

However, in the cerium-based polishing liquid, there is a case where it is difficult to achieve a high polishing rate for silicon oxide, particularly, in polishing of a pattern wafer having a fine concavo-convex pattern configured by a convex portion (for example, Line portion) and a concave portion (for example, Space portion), there is a case where it is difficult to achieve a high polishing rate for silicon oxide of a convex portion.

An aspect of the present disclosure is to provide a polishing liquid for CMP capable of achieving a high polishing rate for silicon oxide of a convex portion in polishing of a pattern wafer having a fine concavo-convex pattern. Furthermore, an object of another aspect of the present disclosure is to provide a polishing liquid set for CMP for obtaining the above-described polishing liquid for CMP. Further, an object of another aspect of the present disclosure is to provide a polishing method which uses the above-described polishing liquid for CMP or the above-described polishing liquid set for CMP.

### Solution to Problem

The present disclosure relates to the following [1] to [17] and the like in several aspects.
[1] A polishing liquid for CMP, containing: abrasive grains; an additive; and water, in which the abrasive grains include cerium-based particles, the additive includes (A1) a 4-pyrone-based compound represented by General Formula (1) below and (B) a compound having two or more nitrogen atoms to which a hydroxyalkyl group is bonded: 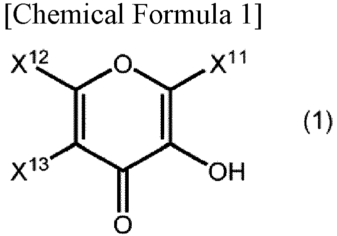 [in the formula, X¹¹, X¹², and X¹³ are each independently a hydrogen atom or a monovalent substituent.]
[2] The polishing liquid for CMP described in [1], in which the component (A1) includes at least one selected from the group consisting of 3-hydroxy-2-methyl-4-pyrone, 5-hydroxy-2-(hydroxymethyl)-4-pyrone, and 2-ethyl-3-hydroxy-4-pyrone.
[3] The polishing liquid for CMP described in [1] or [2], in which a content of the component (A1) is 0.01 to 5% by mass.
[4] The polishing liquid for CMP described in any one of [1] to [3], in which the component (B) includes an ethylenedinitrilotetraethanol.
[5] The polishing liquid for CMP described in any one of [1] to [4], in which the component (B) includes an ethylenedinitrilotetrapropanol.
[6] The polishing liquid for CMP described in any one of [1] to [5], in which a content of the component (B) is 0.001 to 5% by mass.
[7] The polishing liquid for CMP described in any one of [1] to [6], in which the additive further includes a saturated monocarboxylic acid.
[8] The polishing liquid for CMP described in any one of [1] to [7], in which a pH is 8.0 or less.
[9] A polishing liquid for CMP, containing: abrasive grains; an additive; and water, in which the abrasive grains include cerium-based particles, the additive includes (A2) picolinic acid and (B) a compound having two or more nitrogen atoms to which a hydroxyalkyl group is bonded.
[10] The polishing liquid for CMP described in [9], in which a content of the component (A2) is 0.001 to 5% by mass.
[11] The polishing liquid for CMP described in [9] or [10], in which the component (B) includes an ethylenedinitrilotetraethanol.
[12] The polishing liquid for CMP described in any one of [9] to [11], in which the component (B) includes an ethylenedinitrilotetrapropanol.
[13] The polishing liquid for CMP described in any one of [9] to [12], in which a content of the component (B) is 0.001 to 5% by mass.
[14] The polishing liquid for CMP described in any one of [9] to [13], in which a pH is 8.0 or less.
[15] A polishing liquid set for CMP, containing: constituent components of the polishing liquid for CMP described in any one of [1] to [14], separately stored as a first liquid and a second liquid, in which the first liquid contains the abrasive grains and water, and the second liquid contains at least one of the additives and water.
[16] A polishing method including a step of polishing a surface to be polished by using the polishing liquid for CMP described in any one of [1] to [14] or a polishing liquid for CMP obtained by mixing the first liquid and the second liquid of the polishing liquid set for CMP described in [15].
[17] The polishing method described in [16], in which the surface to be polished contains silicon oxide.

### Advantageous Effects of Invention

According to an aspect of the present disclosure, it is possible to provide a polishing liquid for CMP capable of achieving a high polishing rate for silicon oxide of a convex portion in polishing of a pattern wafer having a fine concavo-convex pattern. Furthermore, according to another aspect of the present disclosure, it is possible to provide a polishing liquid set for CMP for obtaining the above-described polishing liquid for CMP. Further, according to another aspect of the present disclosure, it is possible to provide a polishing method which uses the above-described polishing liquid for CMP or the above-described polishing liquid set for CMP.

### Brief Description of Drawings

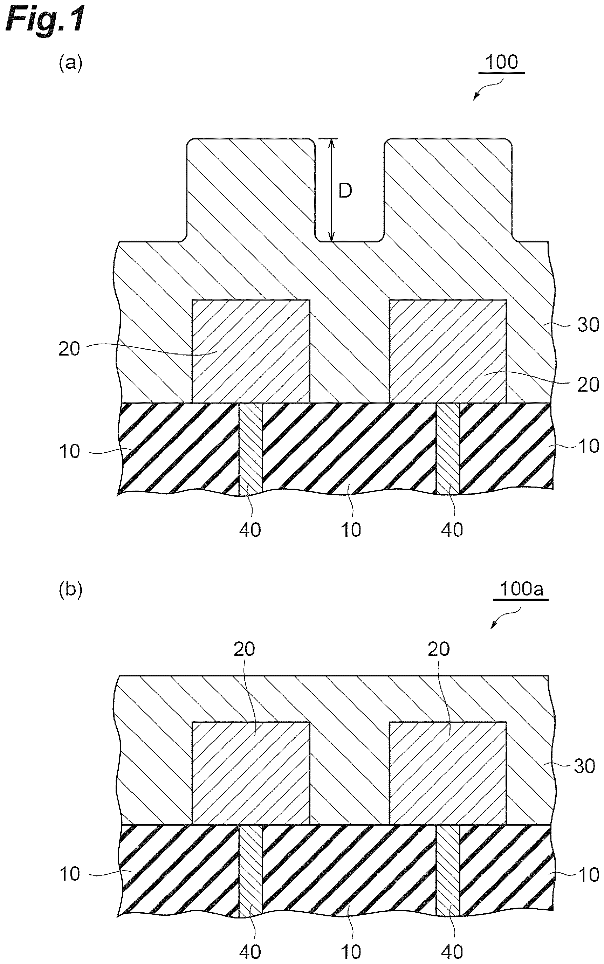

FIG. 1 is a schematic cross-sectional view illustrating the process of polishing an ILD film.

### Description of Embodiments

Hereinafter, an embodiment of the present disclosure will be described in detail.

In the present specification, a numerical range that has been indicated by use of "to" indicates the range that includes the numerical values which are described before and after "to", as the minimum value and the maximum value, respectively. "A or more" in the numerical range means A and a range of more than A. "A or less" in the numerical range means A and a range of less than A. In the numerical ranges that are described stepwise in the present specification, the upper limit value or the lower limit value of the numerical range of a certain stage can be arbitrarily combined with the upper limit value or the lower limit value of the numerical range of another stage. In the numerical ranges that are described in the present specification, the upper limit value or the lower limit value of the numerical range may be replaced with the value shown in Examples. "A or B" may include either one of A and B, and may also include both of A and B. Materials listed as examples in the present specification can be used singly or in combinations of two or more kinds, unless otherwise specified. When a plurality of substances corresponding to each component exist in the composition, the content of each component in the composition means the total amount of the plurality of substances that exist in the composition, unless otherwise specified. The term "layer" or "film" includes a structure having a shape which is formed on a part, in addition to a structure having a shape which is formed on the whole surface, when the film has been observed as a plan view. The term "step" includes not only an independent step but also a step by which an intended action of the step is achieved, though the step cannot be clearly distinguished from other steps. A "hydroxy group" (hydroxyl group) does not include an OH structure contained in a carboxy group.

### <Polishing liquid for CMP>

A polishing liquid for CMP of the present embodiment (a first embodiment and a second embodiment; the same applies hereinafter) is a polishing liquid for CMP (hereinafter, simply referred to as "polishing liquid" in some cases) containing abrasive grains, an additive, and water. The abrasive grains include cerium-based particles (particles containing a cerium-based compound). The additive of the polishing liquid of the first embodiment includes (A1) a 4-pyrone-based compound represented by General Formula (1) below (component (A1)) and (B) a compound having two or more nitrogen atoms to which a hydroxyalkyl group is bonded (component (B)). The additive of the polishing liquid of the second embodiment includes (A2) picolinic acid (component (A2)) and (B) a compound having two or more nitrogen atoms to which a hydroxyalkyl group is bonded (component (B)). The additive of the polishing liquid of the present embodiment may include the component (A1), the component (A2), and the component (B). 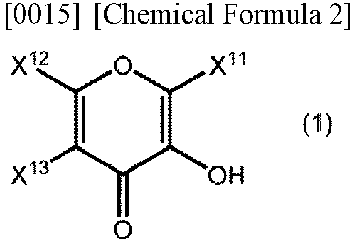 [in the formula, X¹¹, X¹², and X¹³ are each independently a hydrogen atom or a monovalent substituent.]

According to the polishing liquid of the present embodiment, it is possible to achieve a high polishing rate for silicon oxide of a convex portion in polishing of a pattern wafer having a fine concavo-convex pattern configured by a convex portion (for example, Line portion) and a concave portion (for example, Space portion), and for example, it is possible to achieve a high polishing rate for silicon oxide of a convex portion in polishing of a region with Line/Space (L/S) = 30 µm/570 µm of a pattern wafer. According to the polishing liquid of the present embodiment, in an evaluation method described in Examples described below, as a polishing rate for silicon oxide of a convex portion in a region with L/S = 30 µm/570 µm, for example, 2100 nm/min or more can be obtained.

Although a factor by which a high polishing rate for silicon oxide of a convex portion can be achieved is not necessarily clear, the factor is speculated as described below. However, the factor is not limited to the contents to be as follows. That is, according to the polishing liquid of the present embodiment, it is possible to obtain a high polishing rate for silicon oxide of a convex portion by increasing the interaction between the polishing liquid and silicon oxide of a convex portion by the synergetic effect caused by using the component (A1) and the component (B) on combination or by the synergetic effect caused by using the component (A2) and the component (B) in combination (for example, by promoting a chemical reaction (reaction derived from Si-O-Ce bond) between the cerium-based particles in the polishing liquid and silicon oxide of a convex portion), and it is possible to achieve a high polishing rate for silicon oxide of a convex portion in polishing of a region with L/S = 30 µm/570 µm of a pattern wafer.

According to an embodiment of the polishing liquid of the present embodiment, it is possible to achieve a high polishing rate for silicon oxide of a convex portion in polishing of a region with L/S = 30 µm/570 µm of a pattern wafer while achieving high-speed polishing (for example, polishing rate of 100 nm/min or more (preferably 250 nm/min or more, or the like)) of silicon oxide of a blanket wafer having no concavo-convex pattern.

The polishing liquid of the present embodiment can be used for CMP of a semiconductor wafer material, and can be used, for example, for polishing a silicon oxide film provided on a surface of a semiconductor wafer. The polishing liquid of the present embodiment can be used in the CMP step for the ILD film.

### (Abrasive grains)

The abrasive grains include cerium-based particles. By using cerium-based particles as abrasive grains, it is easy to obtain a high polishing rate for silicon oxide of a convex portion of a pattern wafer while reducing polishing scratches on a polished surface.

Examples of the cerium-based compound of the cerium-based particles include cerium oxide, cerium hydroxide, cerium ammonium nitrate, cerium acetate, cerium sulfate hydrate, cerium bromate, cerium bromide, cerium chloride, cerium oxalate, cerium nitrate, and cerium carbonate. The cerium-based particles may contain cerium oxide from the viewpoint of easily obtaining a high polishing rate for silicon oxide of a convex portion (convex portion in a region with L/S = 30 µm/570 µm, or the like; the same applies hereinafter) of a pattern wafer. By using cerium-based particles containing cerium oxide (cerium oxide particles), it is easy to achieve a high polishing rate for silicon oxide of a convex portion of a pattern wafer and easy to obtain a polished surface with few polishing scratches and excellent flatness.

The cerium oxide particles may contain polycrystalline cerium oxide having a grain boundary. Such polycrystalline cerium oxide particles have a property that active planes appear one after another at the same time when the particles become finer during polishing, and can keep a high polishing rate for silicon oxide of a convex portion of a pattern wafer.

Examples of the method for producing the cerium oxide particles include a firing method; and an oxidation method using hydrogen peroxide or the like. In the case of firing, the temperature during firing may be 350 to 900°C. In a case where the produced cerium oxide particles aggregate, the particles may be mechanically pulverized. The pulverizing method may be, for example, dry pulverization with a jet mill or the like; or wet pulverization with a planetary bead mill or the like. For the jet mill, for example, a jet mill described in "Kagaku Kougaku Ronbunshu (Collection of chemical engineering papers)", Vol. 6, No. 5, (1980), pp. 527 to 532 can be used.

The zeta potential (surface potential) of the abrasive grains in the polishing liquid may be positive (the zeta potential may be more than 0 mV) from the viewpoint of easily obtaining a high polishing rate for silicon oxide of a convex portion of a pattern wafer. The zeta potential of the abrasive grains can be measured, for example, by using a dynamic light scattering type zeta potential measurement apparatus (for example, trade name: DelsaNano C manufactured by Beckman Coulter, Inc.). The zeta potential of the abrasive grains can be adjusted using an additive. For example, by bringing an acid component (for example, acetic acid) into contact with abrasive grains, abrasive grains having a positive zeta potential can be obtained.

The average particle diameter of the abrasive grains may be 50 nm or more, 70 nm or more, 100 nm or more, more than 100 nm, 105 nm or more, 110 nm or more, 115 nm or more, 120 nm or more, 125 nm or more, 130 nm or more, 135 nm or more, or 140 nm or more, from the viewpoint of easily obtaining a high polishing rate for silicon oxide of a convex portion of a pattern wafer. The average particle diameter of the abrasive grains may be 500 nm or less, 300 nm or less, 200 nm or less, 180 nm or less, 150 nm or less, or 140 nm or less, from the viewpoint of easily suppressing the occurrence of polishing scratches. From these viewpoints, the average particle diameter of the abrasive grains may be 50 to 500 nm, 50 to 200 nm, 50 to 150 nm, 70 to 500 nm, 70 to 200 nm, 70 to 150 nm, 100 to 500 nm, 100 to 200 nm, or 100 to 150 nm. By adjusting the average particle diameter of the abrasive grains, a high polishing rate for silicon oxide and low scratch characteristics according to the average particle diameter of the abrasive grains are efficiently obtained.

The "average particle diameter of the abrasive grains" means median of the volume distribution measured for an abrasive grain-dispersed slurry sample using a laser diffraction/scattering particle size distribution measuring device, and can be measured using trade name: Microtrac MT3300EXII manufactured by MicrotracBEL Corp., or the like. For example, a sample is prepared by dispersing the abrasive grains in water and adjusting the content of the abrasive grains so that the content of the abrasive grains is 0.25% by mass based on the total mass of the sample, this sample is set in the measuring device, and then the median of the volume distribution is measured. In the case of measuring the particle diameter of the abrasive grains in the polishing liquid, a sample is prepared by adjusting the content of the abrasive grains in the polishing liquid so that the content of the abrasive grains is 0.25% by mass based on the total mass of the sample, and the measurement can be performed using this sample by the same method.

The content of the abrasive grains may be in the following range on the basis of the total mass of the polishing liquid, from the viewpoint of achieving an excellent balance between the polishing rate for silicon oxide of a convex portion of a pattern wafer and the dispersion stability of the abrasive grains. The content of the abrasive grains may be 0.01% by mass or more, 0.05% by mass or more, 0.1% by mass or more, 0.15% by mass or more, 0.2% by mass or more, 0.25% by mass or more, 0.3% by mass or more, 0.5% by mass or more, 0.8% by mass or more, or 1% by mass or more. The content of the abrasive grains may be 10% by mass or less, 5% by mass or less, 3% by mass or less, 1% by mass or less, 0.8% by mass or less, 0.5% by mass or less, 0.3% by mass or less, or 0.25% by mass or less. From these viewpoints, the content of the abrasive grains may be 0.01 to 10% by mass, 0.01 to 2% by mass, 0.01 to 1% by mass, 0.01 to 0.5% by mass, 0.1 to 10% by mass, 0.1 to 2% by mass, 0.1 to 1% by mass, 0.1 to 0.5% by mass, 0.5 to 10% by mass, 0.5 to 2% by mass, or 0.5 to 1% by mass.

### (Additive)

### [Component (A1): 4-pyrone-based compound]

The additive of the polishing liquid of the first embodiment includes, as the component (A1), a 4-pyrone-based compound represented by General Formula (1) (hereinafter, simply referred to as "4-pyrone-based compound" in some cases). It is presumed that the use of the 4-pyrone-based compound increases the interaction between the polishing liquid and silicon oxide, so that the polishing rate is likely to increase. Furthermore, it is considered that, although the 4-pyrone-based compound is an additive capable of increasing the interaction between the polishing liquid and silicon oxide, since the effect of weakening repulsive force such as electrostatic repulsive force between abrasive grains is not obtained, the aggregation of the abrasive grains can be suppressed.

The 4-pyrone-based compound is a compound represented by General Formula (1) below, and is a compound having a structure in which a hydroxy group is bonded to a carbon atom adjacent to a carbon atom of a carbonyl group. The "4-pyrone-based compound" is a heterocyclic compound having a γ-pyrone ring (6-membered ring) which has an oxy group and a carbonyl group and in which the carbonyl group is located at the 4th position with respect to the oxy group. In the 4-pyrone-based compound, the hydroxy group is bonded to the carbon atom adjacent to the carboxy group in this γ-pyrone ring, and other carbon atoms may be substituted with substituents other than hydrogen atoms.
[Chemical Formula 3]

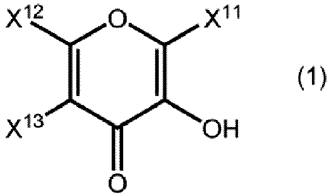

In the formula, X¹¹, X¹², and X¹³ are each independently a hydrogen atom or a monovalent substituent. Examples of the monovalent substituent include an aldehyde group, a hydroxy group, a carboxy group, a carboxylate group, a sulfonic acid group, a phosphoric acid group, a bromine atom, a chlorine atom, an iodine atom, a fluorine atom, a nitro group, a hydrazine group, an alkyl group (for example, an alkyl group having 1 to 8 carbon atoms), an aryl group (for example, an aryl group having 6 to 12 carbon atoms), and an alkenyl group (for example, an alkenyl group having 1 to 8 carbon atoms). The alkyl group, the aryl group, and the alkenyl group may be substituted with OH, COOH, Br, Cl, I, NO₂, or the like. In the case of having a monovalent substituent as X¹¹, X¹², and X¹³, the substituent may be bonded to a carbon atom adjacent to an oxy group, that is, X¹¹ and X¹² may be substituents. At least two of X¹¹, X¹², and X¹³ may be a hydrogen atom.

From the viewpoint of easily obtaining a high polishing rate for silicon oxide of a convex portion of a pattern wafer and the viewpoint of easily suppressing the aggregation of the abrasive grains, the 4-pyrone-based compound may include at least one selected from the group consisting of 3-hydroxy-2-methyl-4-pyrone (also known as: 3-hydroxy-2-methyl-4H-pyran-4-one, maltol), 5-hydroxy-2-(hydroxymethyl)-4-pyrone (also known as: 5-hydroxy-2-(hydroxymethyl)-4H-pyran-4-one, kojic acid), and 2-ethyl-3-hydroxy-4-pyrone (also known as: 2-ethyl-3-hydroxy-4H-pyran-4-one), and may include 3-hydroxy-2-methyl-4-pyrone. The 4-pyrone-based compound can be used singly or in combination of two or more types thereof.

The 4-pyrone-based compound may be water-soluble. By using a compound having a high degree of solubility in water, a desired amount of the additive can be well dissolved in the polishing liquid, and the effects of improving a polishing rate and suppressing the aggregation of the abrasive grains can be achieved at an even higher level. The degree of solubility of the 4-pyrone-based compound with respect to 100 g of water at room temperature (25°C) may be 0.001 g or more, 0.005 g or more, 0.01 g or more, or 0.05 g or more. The upper limit of the degree of solubility is not particularly limited.

The content of the 4-pyrone-based compound may be in the following range on the basis of the total mass of the polishing liquid from the viewpoint of easily obtaining a high polishing rate for silicon oxide of a convex portion of a pattern wafer and the viewpoint of easily achieving high-speed polishing of silicon oxide of a blanket wafer having no concavo-convex pattern. The content of the 4-pyrone-based compound may be 0.001% by mass or more, 0.005% by mass or more, 0.01% by mass or more, 0.015% by mass or more, 0.02% by mass or more, 0.025% by mass or more, 0.03% by mass or more, 0.032% by mass or more, 0.034% by mass or more, 0.035% by mass or more, 0.04% by mass or more, 0.05% by mass or more, 0.08% by mass or more, 0.1% by mass or more, 0.13% by mass or more, 0.15% by mass or more, 0.18% by mass or more, or 0.2% by mass or more. The content of the 4-pyrone-based compound may be 5% by mass or less, 3% by mass or less, 1% by mass or less, 0.8% by mass or less, 0.5% by mass or less, 0.3% by mass or less, 0.2% by mass or less, 0.18% by mass or less, 0.15% by mass or less, 0.13% by mass or less, 0.1% by mass or less, 0.08% by mass or less, 0.05% by mass or less, 0.04% by mass or less, 0.035% by mass or less, or 0.034% by mass or less. From these viewpoints, the content of the 4-pyrone-based compound may be 0.001 to 5% by mass, 0.001 to 1% by mass, 0.001 to 0.3% by mass, 0.001 to 0.1% by mass, 0.001 to 0.05% by mass, 0.01 to 5% by mass, 0.01 to 1% by mass, 0.01 to 0.3% by mass, 0.01 to 0.1% by mass, 0.01 to 0.05% by mass, 0.02 to 5% by mass, 0.02 to 1% by mass, 0.02 to 0.3% by mass, 0.02 to 0.1% by mass, or 0.02 to 0.05% by mass.

A mass ratio A1 of the content of the 4-pyrone-based compound with respect to the content of the abrasive grains (4-pyrone-based compound/abrasive grains) may be in the following range from the viewpoint of easily obtaining a high polishing rate for silicon oxide of a convex portion of a pattern wafer. The mass ratio A1 may be 0.01 or more, 0.03 or more, 0.5 or more, 0.08 or more, 0.1 or more, 0.12 or more, 0.13 or more, 0.15 or more, 0.18 or more, or 0.2 or more. The mass ratio A1 may be 1 or less, less than 1, 0.8 or less, 0.6 or less, 0.5 or less, 0.4 or less, 0.3 or less, 0.2 or less, 0.18 or less, 0.15 or less, 0.13 or less, 0.12 or less, or 0.1 or less. From these viewpoints, the mass ratio A1 may be 0.01 to 1, 0.01 to 0.3, 0.01 to 0.15, 0.1 to 1, 0.1 to 0.3, 0.1 to 0.15, 0.12 to 1, 0.12 to 0.3, or 0.12 to 0.15.

### [Component (A2): picolinic acid]

The additive of the polishing liquid of the second embodiment includes picolinic acid as the component (A2). It is presumed that the use of the component (A2) increases the interaction between the polishing liquid and silicon oxide, so that the polishing rate is likely to increase.

The content of the picolinic acid may be in the following range on the basis of the total mass of the polishing liquid from the viewpoint of easily obtaining a high polishing rate for silicon oxide of a convex portion of a pattern wafer. The content of the picolinic acid may be 0.001% by mass or more, 0.005% by mass or more, 0.01% by mass or more, 0.03% by mass or more, 0.05% by mass or more, 0.08% by mass or more, 0.1% by mass or more, 0.12% by mass or more, 0.15% by mass or more, 0.18% by mass or more, or 0.2% by mass or more. The content of the picolinic acid may be 5% by mass or less, 3% by mass or less, 1% by mass or less, 0.8% by mass or less, 0.5% by mass or less, 0.4% by mass or less, 0.3% by mass or less, or 0.2% by mass or less. From these viewpoints, the content of the picolinic acid may be 0.001 to 5% by mass, 0.001 to 1% by mass, 0.001 to 0.5% by mass, 0.001 to 0.3% by mass, 0.01 to 5% by mass, 0.01 to 1% by mass, 0.01 to 0.5% by mass, 0.01 to 0.3% by mass, 0.1 to 5% by mass, 0.1 to 1% by mass, 0.1 to 0.5% by mass, or 0.1 to 0.3% by mass.

A mass ratio A2 of the content of the picolinic acid with respect to the content of the abrasive grains (picolinic acid/abrasive grains) may be in the following range from the viewpoint of easily obtaining a high polishing rate for silicon oxide of a convex portion of a pattern wafer. The mass ratio A2 may be 0.01 or more, 0.03 or more, 0.05 or more, 0.08 or more, 0.1 or more, 0.12 or more, 0.15 or more, 0.18 or more, or 0.2 or more. The mass ratio A2 may be 1 or less, less than 1, 0.8 or less, 0.6 or less, 0.5 or less, 0.4 or less, 0.3 or less, 0.25 or less, or 0.2 or less. From these viewpoints, the mass ratio A2 may be 0.01 to 1, 0.01 to 0.5, 0.01 to 0.3, 0.01 to 0.2, 0.05 to 1, 0.05 to 0.5, 0.05 to 0.3, 0.05 to 0.2, 0.1 to 1, 0.1 to 0.5, 0.1 to 0.3, or 0.1 to 0.2.

### [Component (B): nitrogen-containing hydroxyalkyl compound]

The additive of the polishing liquid of the present embodiment includes a compound having two or more nitrogen atoms to which a hydroxyalkyl group is bonded (nitrogen-containing hydroxyalkyl compound) as the component (B). In the component (B), the hydroxyalkyl group is directly bonded to the nitrogen atom, and the hydroxy group is directly bonded to the alkyl group directly bonded to the nitrogen atom. In the component (B), an alkyl group having no substituent other than a hydroxy group can be used as the hydroxyalkyl group bonded to the nitrogen atom.

From the viewpoint of easily obtaining a high polishing rate for silicon oxide of a convex portion of a pattern wafer, the component (B) may include a compound having a nitrogen atom to which two hydroxyalkyl groups are bonded, and may include a compound having two or more nitrogen atoms to which two hydroxyalkyl groups are bonded.

From the viewpoint of easily obtaining a high polishing rate for silicon oxide of a convex portion of a pattern wafer, the number of nitrogen atoms in one molecule of the component (B) may be 2 to 5, 2 to 4, or 2 to 3. From the viewpoint of easily obtaining a high polishing rate for silicon oxide of a convex portion of a pattern wafer, the number of hydroxy groups in one molecule of the component (B) may be 2 to 6, 2 to 5, 2 to 4, 3 to 6, 3 to 5, 3 to 4, 4 to 6, or 4 to 5.

From the viewpoint of easily obtaining a high polishing rate for silicon oxide of a convex portion of a pattern wafer, the component (B) may have a hydroxyalkyl group having 1 to 4, 2 to 4, 3 to 4, 1 to 3, 2 to 3, or 1 to 2 carbon atoms as the hydroxyalkyl group bonded to the nitrogen atom. From the viewpoint of easily obtaining a high polishing rate for silicon oxide of a convex portion of a pattern wafer, the component (B) may have a hydroxyalkyl group having the number of hydroxy groups of 1 to 3 or 1 to 2 as the hydroxyalkyl group bonded to the nitrogen atom.

From the viewpoint of easily obtaining a high polishing rate for silicon oxide of a convex portion of a pattern wafer, the component (B) may have an alkylene group between two nitrogen atoms to which the hydroxyalkyl group is bonded, and the number of carbon atoms of the alkylene group may be 1 to 4, 2 to 4, 1 to 3, 2 to 3, or 1 to 2.

From the viewpoint of easily obtaining a high polishing rate for silicon oxide of a convex portion of a pattern wafer, the component (B) may include a compound represented by General Formula (I) below. 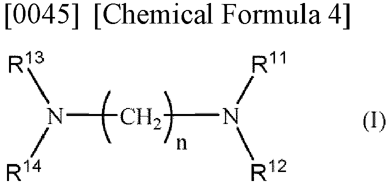 [in the formula, n is an integer of 1 or more, R¹¹, R¹², R¹³, and R¹⁴ each independently represent a hydrogen atom or an organic group, one or both of R¹¹ and R¹² are a hydroxyalkyl group, and one or both of R¹³ and R¹⁴ are a hydroxyalkyl group.]

n may be in the aforementioned range for the number of carbon atoms of the alkylene group between two nitrogen atoms to which the hydroxyalkyl group is bonded. The organic group may be a substituted or unsubstituted alkyl group, may be a hydroxyalkyl group, and may be a group having a nitrogen atom to which a hydroxyalkyl group is bonded. Examples of the substituent of the alkyl group include a hydroxy group, a carboxy group, an amino group, a sulfo group, and a nitro group. In a case where R¹¹, R¹², R¹³, or R¹⁴ is a hydroxyalkyl group, the number of carbon atoms of the hydroxyalkyl group may be in the aforementioned range for the number of carbon atoms of the hydroxyalkyl group bonded to the nitrogen atom.

Examples of the component (B) include an ethylenedinitrilotetraethanol (THEED: 2,2',2",2‴-ethylenedinitrilotetraethanol (also known as: N,N,N',N'-Tetrakis(2-hydroxyethyl)ethylenediamine) and the like), an ethylenedinitrilotetrapropanol (EDTP: 1,1',1",1‴-ethylenedinitrilotetra-2-propanol (also known as: N,N,N',N'-Tetrakis(2-hydroxypropyl)ethylenediamine) and the like), and N,N,N',N",N"-pentakis(2-hydroxypropyl)diethylenetriamine. From the viewpoint of easily obtaining a high polishing rate for silicon oxide of a convex portion of a pattern wafer and the viewpoint of easily achieving high-speed polishing of silicon oxide of a blanket wafer having no concavo-convex pattern, the component (B) may include at least one selected from the group consisting of an ethylenedinitrilotetraethanol and an ethylenedinitrilotetrapropanol, may include an ethylenedinitrilotetraethanol, and may include an ethylenedinitrilotetrapropanol. From the viewpoint of easily obtaining a high polishing rate for silicon oxide of a convex portion of a pattern wafer, the component (B) may include a compound having no carboxy group.

The molecular weight of the component (B) may be in the following range from the viewpoint of easily obtaining a high polishing rate for silicon oxide of a convex portion of a pattern wafer. The molecular weight of the component (B) may be 50 or more, 60 or more, 70 or more, 80 or more, 85 or more, 90 or more, 100 or more, 110 or more, 120 or more, 123 or more, 125 or more, 130 or more, 140 or more, 148 or more, 150 or more, 160 or more, 170 or more, 180 or more, 200 or more, 210 or more, 230 or more, 250 or more, more than 250, or 280 or more. The molecular weight of the component (B) may be 1000 or less, less than 1000, 900 or less, 800 or less, 700 or less, 600 or less, 500 or less, 400 or less, 350 or less, 300 or less, 280 or less, 250 or less, less than 250, or 240 or less. From these viewpoints, the molecular weight of the component (B) may be 50 to 1000, 50 to 500, 50 to 300, 50 to 250, 200 to 1000, 200 to 500, 200 to 300, 200 to 250, 250 to 1000, 250 to 500, or 250 to 300.

In the polishing liquid of the first embodiment, as the content of the component (B), the content of the ethylenedinitrilotetraethanol, or the content of the ethylenedinitrilotetrapropanol, a content B1 may be in the following range on the basis of the total mass of the polishing liquid from the viewpoint of easily obtaining a high polishing rate for silicon oxide of a convex portion of a pattern wafer. The content B1 may be 0.001% by mass or more, 0.005% by mass or more, 0.01% by mass or more, 0.015% by mass or more, 0.02% by mass or more, 0.025% by mass or more, 0.03% by mass or more, 0.035% by mass or more, 0.04% by mass or more, 0.045% by mass or more, or 0.05% by mass or more. The content B1 may be 5% by mass or less, 3% by mass or less, 1% by mass or less, 0.5% by mass or less, 0.4% by mass or less, 0.3% by mass or less, 0.2% by mass or less, 0.15% by mass or less, 0.1% by mass or less, 0.08% by mass or less, 0.06% by mass or less, 0.05% by mass or less, 0.045% by mass or less, 0.04% by mass or less, 0.035% by mass or less, 0.03% by mass or less, 0.025% by mass or less, or 0.02% by mass or less. From these viewpoints, the content B1 may be 0.001 to 5% by mass, 0.001 to 1% by mass, 0.001 to 0.1% by mass, 0.001 to 0.05% by mass, 0.01 to 5% by mass, 0.01 to 1% by mass, 0.01 to 0.1% by mass, 0.01 to 0.05% by mass, 0.02 to 5% by mass, 0.02 to 1% by mass, 0.02 to 0.1% by mass, or 0.02 to 0.05% by mass.

In the polishing liquid of the second embodiment, as the content of the component (B), the content of the ethylenedinitrilotetraethanol, or the content of the ethylenedinitrilotetrapropanol, a content B2 may be in the following range on the basis of the total mass of the polishing liquid from the viewpoint of easily obtaining a high polishing rate for silicon oxide of a convex portion of a pattern wafer and the viewpoint of easily achieving high-speed polishing of silicon oxide of a blanket wafer having no concavo-convex pattern. The content B2 may be 0.001 % by mass or more, 0.005% by mass or more, 0.01% by mass or more, 0.015% by mass or more, 0.02% by mass or more, 0.025% by mass or more, 0.03% by mass or more, 0.035% by mass or more, 0.04% by mass or more, 0.045% by mass or more, 0.05% by mass or more, 0.06% by mass or more, 0.08% by mass or more, 0.1% by mass or more, 0.12% by mass or more, 0.13% by mass or more, 0.15% by mass or more, 0.2% by mass or more, or 0.22% by mass or more. The content B2 may be 5% by mass or less, 3% by mass or less, 1% by mass or less, 0.5% by mass or less, 0.4% by mass or less, 0.3% by mass or less, 0.22% by mass or less, 0.2% by mass or less, 0.15% by mass or less, 0.13% by mass or less, 0.12% by mass or less, 0.1% by mass or less, 0.08% by mass or less, 0.06% by mass or less, 0.05% by mass or less, 0.045% by mass or less, 0.04% by mass or less, 0.035% by mass or less, 0.03% by mass or less, 0.025% by mass or less, 0.02% by mass or less, 0.015% by mass or less, or 0.01% by mass or less. From these viewpoints, the content B2 may be 0.001 to 5% by mass, 0.001 to 1% by mass, 0.001 to 0.3% by mass, 0.001 to 0.05% by mass, 0.01 to 5% by mass, 0.01 to 1% by mass, 0.01 to 0.3% by mass, 0.01 to 0.05% by mass, 0.02 to 5% by mass, 0.02 to 1% by mass, 0.02 to 0.3% by mass, or 0.02 to 0.05% by mass.

In the polishing liquid of the first embodiment, as the mass ratio of the content of the component (B) with respect to the content of the abrasive grains (component (B)/abrasive grains), the mass ratio of the ethylenedinitrilotetraethanol with respect to the content of the abrasive grains (ethylenedinitrilotetraethanol/abrasive grains), or the mass ratio of the content of the ethylenedinitrilotetrapropanol with respect to the content of the abrasive grains (ethylenedinitrilotetrapropanol/abrasive grains), a mass ratio B11 may be in the following range from the viewpoint of easily obtaining a high polishing rate for silicon oxide of a convex portion of a pattern wafer. The mass ratio B11 may be 0.001 or more, 0.005 or more, 0.01 or more, 0.02 or more, 0.03 or more, 0.05 or more, 0.08 or more, 0.1 or more, 0.12 or more, 0.15 or more, 0.18 or more, or 0.2 or more. The mass ratio B11 may be 10 or less, 5 or less, 2 or less, 1 or less, less than 1, 0.5 or less, 0.3 or less, 0.2 or less, 0.18 or less, 0.15 or less, 0.12 or less, 0.1 or less, 0.08 or less, 0.05 or less, 0.03 or less, or 0.02 or less. From these viewpoints, the mass ratio B11 may be 0.001 to 10, 0.001 to 1, 0.001 to 0.3, 0.001 to 0.1, 0.01 to 10, 0.01 to 1, 0.01 to 0.3, 0.01 to 0.1, 0.02 to 10, 0.02 to 1, 0.02 to 0.3, or 0.02 to 0.1.

In the polishing liquid of the second embodiment, as the mass ratio of the content of the component (B) with respect to the content of the abrasive grains (component (B)/abrasive grains), the mass ratio of the ethylenedinitrilotetraethanol with respect to the content of the abrasive grains (ethylenedinitrilotetraethanol/abrasive grains), or the mass ratio of the content of the ethylenedinitrilotetrapropanol with respect to the content of the abrasive grains (ethylenedinitrilotetrapropanol/abrasive grains), a mass ratio B21 may be in the following range from the viewpoint of easily obtaining a high polishing rate for silicon oxide of a convex portion of a pattern wafer. The mass ratio B21 may be 0.001 or more, 0.005 or more, 0.01 or more, 0.02 or more, 0.03 or more, 0.04 or more, 0.05 or more, 0.06 or more, 0.08 or more, 0.1 or more, 0.13 or more, 0.15 or more, 0.2 or more, or 0.22 or more. The mass ratio B21 may be 10 or less, 5 or less, 2 or less, 1 or less, less than 1, 0.5 or less, 0.3 or less, 0.25 or less, 0.22 or less, 0.2 or less, 0.15 or less, 0.13 or less, 0.1 or less, 0.08 or less, 0.06 or less, 0.05 or less, 0.04 or less, 0.03 or less, 0.02 or less, or 0.01 or less. From these viewpoints, the mass ratio B21 may be 0.001 to 10, 0.001 to 1, 0.001 to 0.3, 0.001 to 0.2, 0.01 to 10, 0.01 to 1, 0.01 to 0.3, 0.01 to 0.2, 0.03 to 10, 0.03 to 1, 0.03 to 0.3, or 0.03 to 0.2.

In the polishing liquid of the first embodiment, as the mass ratio of the content of the component (B) with respect to the content of the component (A1) (component (B)/component (A1)), the mass ratio of the ethylenedinitrilotetraethanol with respect to the content of the component (A1) (ethylenedinitrilotetraethanol/component (A1)), or the mass ratio of the content of the ethylenedinitrilotetrapropanol with respect to the content of the component (A1) (ethylenedinitrilotetrapropanol/component (A1)), a mass ratio B12 may be in the following range from the viewpoint of easily obtaining a high polishing rate for silicon oxide of a convex portion of a pattern wafer. The mass ratio B12 may be 0.01 or more, 0.05 or more, 0.1 or more, 0.15 or more, 0.2 or more, 0.3 or more, 0.5 or more, 0.6 or more, 0.8 or more, 0.85 or more, 0.9 or more, 1 or more, more than 1, 1.1 or more, 1.2 or more, or 1.4 or more. The mass ratio B12 may be 10 or less, 8 or less, 5 or less, 2 or less, 1.5 or less, 1.4 or less, 1.2 or less, 1.1 or less, 1 or less, less than 1, 0.9 or less, 0.85 or less, 0.8 or less, 0.6 or less, 0.5 or less, 0.3 or less, 0.2 or less, 0.15 or less, or 0.1 or less. From these viewpoints, the mass ratio B12 may be 0.01 to 10, 0.01 to 2, 0.01 to 1, 0.01 to 0.5, 0.05 to 10, 0.05 to 2, 0.05 to 1, 0.05 to 0.5, 0.15 to 10, 0.15 to 2, 0.15 to 1, or 0.15 to 0.5.

In the polishing liquid of the second embodiment, as the mass ratio of the content of the component (B) with respect to the content of the component (A2) (component (B)/component (A2)), the mass ratio of the ethylenedinitrilotetraethanol with respect to the content of the component (A2) (ethylenedinitrilotetraethanol/component (A2)), or the mass ratio of the content of the ethylenedinitrilotetrapropanol with respect to the content of the component (A2) (ethylenedinitrilotetrapropanol/component (A2)), a mass ratio B22 may be in the following range from the viewpoint of easily obtaining a high polishing rate for silicon oxide of a convex portion of a pattern wafer. The mass ratio B22 may be 0.01 or more, 0.05 or more, 0.1 or more, 0.15 or more, 0.2 or more, 0.25 or more, 0.3 or more, 0.5 or more, 0.6 or more, 0.65 or more, 0.7 or more, 0.8 or more, 1 or more, more than 1, or 1.1 or more. The mass ratio B22 may be 10 or less, 8 or less, 5 or less, 2 or less, 1.5 or less, 1.2 or less, 1.1 or less, 1 or less, less than 1, 0.8 or less, 0.7 or less, 0.65 or less, 0.6 or less, 0.5 or less, 0.3 or less, 0.25 or less, 0.2 or less, 0.15 or less, 0.1 or less, or 0.05 or less. From these viewpoints, the mass ratio B22 may be 0.01 to 10, 0.01 to 2, 0.01 to 1, 0.01 to 0.8, 0.1 to 10, 0.1 to 2, 0.1 to 1, 0.1 to 0.8, 0.2 to 10, 0.2 to 2, 0.2 to 1, or 0.2 to 0.8.

### [Saturated monocarboxylic acid]

The additive of the polishing liquid of the present embodiment may include a saturated monocarboxylic acid. By using the saturated monocarboxylic acid, advantages are obtained in which it is possible not only to easily obtain a sufficiently low polishing rate for silicon nitride that can be used as a stopper material and to improve the dispersibility of the cerium-based particles but also to improve the in-plane uniformity, which is an index of a variation in the polishing rate of the surface to be polished, without lowering the polishing rate for a pattern wafer (for example, a semiconductor substrate having a concavo-convex pattern).

Examples of the saturated monocarboxylic acid include acetic acid, propionic acid, butyric acid, isobutyric acid, valeric acid, isovaleric acid, pivalic acid, hydroangelic acid, caproic acid, 2-methylpentanoic acid, 4-methylpentanoic acid, 2,3-dimethylbutanoic acid, 2-ethylbutanoic acid, 2,2-dimethylbutanoic acid, and 3,3-dimethylbutanoic acid. The saturated monocarboxylic acid may include an aliphatic carboxylic acid from the viewpoint of easily obtaining the aforementioned effect of addition of the saturated monocarboxylic acid. From the viewpoint of effectively obtaining the effect of suppressing the polishing rate for silicon nitride and the viewpoint of further favorably obtaining the effect of improving the in-plane uniformity, the saturated monocarboxylic acid may include a saturated monocarboxylic acid having 2 to 6 carbon atoms, and may include at least one selected from the group consisting of acetic acid and propionic acid.

The content of the saturated monocarboxylic acid (for example, saturated monocarboxylic acid having 2 to 6 carbon atoms) may be in the following range on the basis of the total mass of the polishing liquid from the viewpoint of effectively obtaining the effect of improving the in-plane uniformity, the effect of improving the polishing rate for a pattern wafer, and the effect of suppressing the polishing rate for silicon nitride. The content of the saturated monocarboxylic acid may be 0.0001% by mass or more, 0.0005% by mass or more, 0.001% by mass or more, 0.002% by mass or more, 0.005% by mass or more, 0.01% by mass or more, 0.02% by mass or more, 0.03% by mass or more, 0.04% by mass or more, or 0.045% by mass or more. The content of the saturated monocarboxylic acid may be 5% by mass or less, 3% by mass or less, 1% by mass or less, 0.5% by mass or less, 0.4% by mass or less, 0.3% by mass or less, 0.2% by mass or less, 0.1% by mass or less, 0.05% by mass or less, or 0.045% by mass or less. From these viewpoints, the content of the saturated monocarboxylic acid may be 0.0001 to 5% by mass, 0.0001 to 1% by mass, 0.0001 to 0.1% by mass, 0.0001 to 0.05% by mass, 0.01 to 5% by mass, 0.01 to 1% by mass, 0.01 to 0.1% by mass, 0.01 to 0.05% by mass, 0.03 to 5% by mass, 0.03 to 1% by mass, 0.03 to 0.1% by mass, or 0.03 to 0.05% by mass. The content of the saturated monocarboxylic acid may be 0.04% by mass or less, 0.03% by mass or less, 0.02% by mass or less, 0.01% by mass or less, 0.005% by mass or less, 0.002% by mass or less, 0.001% by mass or less, 0.0005% by mass or less, or substantially 0% by mass.

### [Other additives]

The additive of the polishing liquid of the present embodiment may further include other component (component not corresponding to each component mentioned above) according to desired characteristics. Examples of such a component include a nonionic polymer; a cationic compound; a pH adjusting agent described below; a polar solvent such as ethanol and acetone; and a cyclic monocarboxylic acid.

The polishing liquid of the present embodiment may contain a compound a having a molecular weight of 100000 or less and having four or more hydroxy groups, or may not contain the compound a. The polishing liquid of the present embodiment may contain a compound b having four or more amino groups, or may not contain the compound b. The content of the compound b may be 0.001% by mass or less, less than 0.001% by mass, 0.0001% by mass or less, 0.00001% by mass or less, or substantially 0% by mass, on the basis of the total mass of the polishing liquid. The mass ratio of the content of the compound a with respect to the content of the compound b (compound a/ compound b) may be 0.10 or less or less than 0.10.

### (Water)

Water is not particularly limited, and may include at least one selected from the group consisting of deionized water, ion-exchange water, and ultrapure water.

### (pH)

The pH of the polishing liquid of the present embodiment may be in the following range. The pH may be 12.0 or less, 11.0 or less, 10.5 or less, less than 10.5, 10.0 or less, less than 10.0, 9.5 or less, 9.0 or less, less than 9.0, 8.5 or less, 8.0 or less, less than 8.0, 7.5 or less, 7.3 or less, 7.0 or less, less than 7.0, 6.5 or less, 6.0 or less, less than 6.0, 5.6 or less, 5.5 or less, less than 5.5, 5.1 or less, 5.0 or less, 4.8 or less, 4.7 or less, 4.6 or less, 4.5 or less, 4.4 or less, 4.3 or less, 4.2 or less, 4.1 or less, or 4.0 or less, from the viewpoint of easily suppressing the aggregation of the abrasive grains or the like, the viewpoint of easily obtaining a high polishing rate for silicon oxide of a convex portion of a pattern wafer, the viewpoint of easily suppressing the polishing rate for silicon nitride that can be used as a stopper material, and the viewpoint of easily obtaining the effect of addition of the additive. The pH may be 3.0 or more, 3.5 or more, 3.7 or more, 3.8 or more, 4.0 or more, more than 4.0, 4.1 or more, 4.2 or more, 4.3 or more, 4.4 or more, 4.5 or more, 4.6 or more, 4.7 or more, 4.8 or more, 5.0 or more, 5.1 or more, 5.5 or more, more than 5.5, 5.6 or more, 6.0 or more, more than 6.0, 6.5 or more, 7.0 or more, more than 7.0, or 7.3 or more, from the viewpoint of easily suppressing silicon oxide to be polished from having a zeta potential with a large absolute value on the same positive side as cerium-based particles (for example, cerium oxide particles) and easily obtaining a high polishing rate for silicon oxide of a convex portion of a pattern wafer. From these viewpoints, the pH may be 3.0 to 12.0, 3.0 or more and less than 9.0, 3.0 to 8.0, 3.0 to 5.5, 3.0 to 5.0, 3.5 to 12.0, 3.5 or more and less than 9.0, 3.5 to 8.0, 3.5 to 5.5, 3.5 to 5.0, 4.0 to 12.0, 4.0 or more and less than 9.0, 4.0 to 8.0, 4.0 to 5.5, or 4.0 to 5.0. The pH can be measured by a method described in Examples.

Since the pH can vary depending on the type of a compound used as an additive, a pH adjusting agent may be used for adjusting the pH in the above range. The pH adjusting agent is not particularly limited, and examples thereof include acids such as nitric acid, sulfuric acid, hydrochloric acid, phosphoric acid, and boric acid; and bases such as sodium hydroxide, ammonia (for example, ammonia water), potassium hydroxide, and calcium hydroxide. The aforementioned additive such as a saturated monocarboxylic acid may be used for pH adjustment. From the viewpoint of improving the productivity, a polishing liquid is prepared without using a pH adjusting agent, and this polishing liquid may be applied directly to CMP.

### <Preparation method and usage method of polishing liquid>

The polishing liquid of the present embodiment can be categorized as (a) a normal type, (b) a concentrated type, and (c) a multiple-liquid type (for example, two-liquid type; polishing liquid set for CMP), and the preparation methods and the usage methods differ depending on the type. The (a) normal type is a polishing liquid that can be used directly without pretreatment such as dilution at the time of polishing. The (b) concentrated type is a polishing liquid in which the components are more concentrated than in the (a) normal type, taking into consideration the convenience of storage or transportation. The (c) multiple-liquid type is a polishing liquid that, during storage or transportation, is kept as a state where the components are separated into multiple liquids (for example, a state of being separated into a first liquid containing certain components and a second liquid containing other components), the liquids being mixed and used at the time of use.

The (a) normal type can be obtained by dissolving or dispersing the abrasive grains and the additive in water as a main dispersion medium. For example, in order to prepare 1000 g of the polishing liquid in which the content of the abrasive grains is 0.5 parts by mass and the content of the additive is 0.1 parts by mass with respect to 100 parts by mass of the polishing liquid, the blended amounts may be adjusted for 5 g of the abrasive grains and 1 g of the additive with respect to the total amount of the polishing liquid.

The polishing liquid can be prepared using, for example, a stirrer, a homogenizer, an ultrasonic dispersing machine, a wet ball mill, or the like. Note that, the abrasive grains may be subjected to a micronization treatment in the process of preparation of the polishing liquid so that the average particle diameter of the abrasive grains is in a desired range. The micronization treatment of the abrasive grains can be performed by a precipitating classification method or a method using a high-pressure homogenizer. The precipitating classification method is a method including a step of forcibly precipitating a slurry containing abrasive grains with a centrifugal separator and a step of removing out only the supernatant solution. Meanwhile, the method using a high-pressure homogenizer is a method in which abrasive grains in a dispersion medium collide with each other at a high pressure.

The (b) concentrated type is diluted with water immediately before use to the desired contents of the components. After dilution, stirring may be performed for any length of time until liquid properties (such as pH and the particle diameter of the abrasive grains) and polishing properties (such as the polishing rate for silicon oxide and the polishing selection ratio of silicon oxide and silicon nitride) equivalent to the (a) normal type are obtained. In the (b) concentrated type as described above, the volume is reduced commensurately with the degree of concentration, and it is thus possible to lower storage and transport costs.

The concentration rate may be 1.5 times or more, 2 times or more, 3 times or more, or 5 times or more. When the concentration rate is 1.5 times or more, there is a tendency that advantages for storage and transport are more easily obtained than in a case where the concentration rate is less than 1.5 times. The concentration rate may be 40 times or less, 20 times or less, or 15 times or less. When the concentration rate is 40 times or less, there is a tendency that the aggregation of the abrasive grains is more easily suppressed than in a case where the concentration rate is more than 40 times.

The (c) multiple-liquid type has the advantage of allowing the aggregation of the abrasive grains to be avoided as compared to the (b) concentrated type by appropriately separating each liquid (such as the first liquid and the second liquid). Here, components to be contained in each liquid are any components. The (c) multiple-liquid type (polishing liquid set for CMP) is a polishing liquid set for obtaining a polishing liquid by mixing a first liquid (slurry) and a second liquid (additive liquid). In the (c) multiple-liquid type, the constituent components of the polishing liquid for CMP are stored separately in the first liquid and the second liquid, the first liquid contains the abrasive grains and water, and the second liquid contains at least one of the additives and water. In a first embodiment of the (c) multiple-liquid type, the first liquid contains the abrasive grains and water, and the second liquid contains at least one selected from the group consisting of the component (A1) and the component (A2), the component (B), and water. In a second embodiment of the (c) multiple-liquid type, the first liquid contains the abrasive grains and at least one selected from the group consisting of the component (A1) and the component (A2) and water, and the second liquid contains the component (B) and water. In a third embodiment of the (c) multiple-liquid type, the first liquid contains the abrasive grains, one of the component (A1) and the component (A2), the component (B), and water, and the second liquid contains the other of the component (A1) and the component (A2) and water. In a fourth embodiment of the (c) multiple-liquid type, the first liquid contains the abrasive grains, the component (B), and water, and the second liquid contains at least one selected from the group consisting of the component (A1) and the component (A2) and water. The first liquid and the second liquid may contain other components to be blended as necessary. In this case, in order to enhance the dispersibility of the abrasive grains in the first liquid, any acid or alkali may be blended in the first liquid to adjust the pH.

The polishing liquid of the (c) multiple-liquid type is useful in the case of combinations of components that, when mixed, tend to degrade the polishing properties in a relatively short period of time by the aggregation of the abrasive grains, or the like. Note that, from the viewpoint of reducing storage and transportation costs, at least one of respective liquids (such as the first liquid and the second liquid) may be a concentrated type. In this case, when the polishing liquid is used, each liquid and water may be mixed. The concentration rate and the pH of each liquid are any concentration rate and pH, as long as the final mixture may have liquid properties and polishing properties equivalent to those of the polishing liquid of the (a) normal type.

### <Polishing method>

A polishing method of the present embodiment includes a polishing step of polishing a surface to be polished by using the polishing liquid of the present embodiment. The polishing liquid used in the polishing step may be a polishing liquid obtained by mixing the first liquid and the second liquid of the aforementioned polishing liquid set. That is, the polishing method of the present embodiment may include a polishing step of polishing a surface to be polished by using a polishing liquid obtained by mixing the first liquid and the second liquid of the aforementioned polishing liquid set.

The polishing method of the present embodiment uses a polishing liquid in which the content of each component, the pH, and the like are adjusted and can flatten a base substrate having a silicon oxide film on a surface thereof by the CMP technique. The polishing method of the present embodiment is suitable for polishing that requires high speed, high flatness, and low polishing scratches, such as polishing of the ILD film, and is suitable for polishing many ILD films in a short time.

The polishing step may be a step of supplying the polishing liquid of the present embodiment between a base substrate and a polishing member (a member for polishing; a polishing pad or the like) to polish the base substrate by the polishing member. The polishing method of the present embodiment is suitable for polishing a base substrate having a silicon oxide film on a surface thereof. Therefore, the surface to be polished may contain silicon oxide, and the polishing step may be a step of supplying the polishing liquid of the present embodiment between a silicon oxide film in a base substrate having a silicon oxide film on a surface thereof and a polishing member to polish the silicon oxide film by the polishing member.

The polishing method of the present embodiment is suitable for polishing a base substrate having a silicon oxide film on the surface thereof in the production process of a device. Examples of the device include a discrete semiconductor such as diode, transistor, compound semiconductor, thermistor, varistor, and thyristor; a memory element such as DRAM (dynamic random access memory), SRAM (static random access memory), EPROM (erasable programmable read-only memory), mask ROM (mask read-only memory), EEPROM (electrically erasable programmable read-only memory), and flash memory; a logic circuit element such as a microprocessor, DSP, and ASIC; an integrated circuit element such as a compound semiconductor typified by MMIC (monolithic microwave integrated circuit); a hybrid integrated circuit (hybrid IC); a light emitting diode; and a photoelectric conversion element such as a charge-coupled element.

According to an embodiment of the polishing liquid of the present embodiment, a high polishing rate can be achieved without greatly depending on the concavo-convex shape of the surface to be polished. Therefore, the polishing method using this polishing liquid can be applied to a base substrate for which it is difficult to achieve a high polishing rate in a method using a conventional polishing liquid.

The polishing method of the present embodiment is suitable for flattening of a surface to be polished having step height (irregularities) on the surface thereof. Examples of the base substrate having such a surface to be polished include logic semiconductor devices. Furthermore, the polishing method of the present embodiment is suitable for polishing a surface including a portion where a concave portion or a convex portion is T-shaped or grid-shaped when viewed from above. For example, the polishing method of the present embodiment can polish a silicon oxide film provided on a surface of a semiconductor device (a DRAM, a flash memory, or the like) having a memory cell at a high rate. It has been difficult to achieve a high polishing rate for these in a method using a conventional polishing liquid for CMP, and it is shown that an embodiment of the polishing liquid of the present embodiment can achieve a high polishing rate without greatly depending on the concavo-convex shape of the surface to be polished.

The base substrate is not limited to a base substrate having only a silicon oxide film on a surface thereof, and may be a base substrate further having a silicon nitride film, a polycrystalline film, or the like in addition to the silicon oxide film on a surface thereof. The base substrate may be a base substrate having, on a wiring board having a predetermined wiring, an inorganic insulating film such as silicon oxide, glass, or silicon nitride; a film mainly containing polysilicon, Al, Cu, Ti, TiN, W, Ta, TaN, or the like; and the like.

Hereinafter, as an example of a process including the polishing method of the present embodiment, a process of forming an ILD film (interlayer insulating film) structure by CMP will be described. FIG. 1 is a schematic cross-sectional view illustrating the process of polishing an ILD film, and shows the process of forming an ILD film between wirings. FIG. 1(a) is a schematic cross-sectional view illustrating a base substrate before polishing. FIG. 1(b) is a schematic cross-sectional view illustrating the base substrate after polishing.

As illustrated in FIG. 1(a), in a base substrate 100 before polishing, a wiring 20 is formed via an ILD film 10 on a lower substrate (not illustrated) having a predetermined lower wiring (not illustrated), and a silicon oxide film 30 is formed so as to cover this wiring 20. Since the silicon oxide film 30 is formed on the ILD film 10 on which the wiring 20 is formed, portions on the wiring 20 are higher than other portions, thereby resulting in a step height D on the surface of the silicon oxide film 30. The wiring 20 is connected to a lower wiring or the like by a contact plug 40 formed so as to penetrate the ILD film 10.

In the process of forming the ILD film structure, in order to eliminate the step height D, partially protruding unnecessary parts on the surface of the silicon oxide film 30 are preferentially removed by CMP. To polish the silicon oxide film 30, the base substrate 100 is disposed on a polishing member so that the surface of the silicon oxide film 30 and the polishing member are in contact with each other, and the surface of the silicon oxide film 30 is polished by this polishing member. More specifically, the surface to be polished (surface) side of the silicon oxide film 30 is pressed against a polishing member of a polishing platen, and the silicon oxide film 30 is polished by relatively moving the surface to be polished and the polishing member while the polishing liquid is supplied therebetween. Thereby, the step height D is eliminated, and finally, as illustrated in FIG. 1(b), the height of the portion of the wiring 20 on the surface of the silicon oxide film 30 and the height of the other portions become almost the same, and a base substrate 100a having the silicon oxide film 30 (ILD film) with a flat surface is obtained.

As the polishing apparatus used for polishing, for example, an apparatus provided with a holder for holding a base substrate, a polishing platen to which a polishing pad is attached, and a means for supplying a polishing liquid onto the polishing pad can be used. Examples of the polishing apparatus include polishing apparatuses (Model Nos.: EPO-111, EPO-222, F-REX200, and F-REX300) manufactured by EBARA CORPORATION and polishing apparatuses (trade name: Mirra3400 and Reflexion) manufactured by Applied Materials, Inc. The constituent material of the polishing pad is not particularly limited, and for example, a general nonwoven fabric, foamed polyurethane, a porous fluororesin, or the like can be used. Furthermore, the polishing pad may be subjected to groove processing by which the polishing liquid accumulates thereon.

The polishing conditions are not particularly limited, but the rotational speed of the polishing platen may be 200 min⁻¹ or less from the viewpoint of suppressing the flying-off of the base substrate. The pressure (processing load) applied to the base substrate may be 100 kPa or less from the viewpoint of easily suppressing the polishing scratches on the polished surface. The polishing liquid may be continuously supplied to the polishing pad with a pump or the like during polishing. The amount supplied for this is not limited, but the surface of the polishing pad may be always covered with the polishing liquid. The base substrate may be sufficiently washed in running water after the completion of polishing, then dried after removing droplets, which have attached onto the base substrate, with the use of a spin dry or the like.

Polishing as described above allows irregularities on the surface to be eliminated, and thereby a smooth surface across the entire base substrate can be obtained. Furthermore, by repeating the steps of forming a film and polishing this film a predetermined number of times, a structure having desired number of layers can be produced.

The base substrate (structure) obtained in this way can be used as various electronic components. Specific examples of the electronic components include semiconductor elements; optical glass for a photomask, a lens, and a prism; inorganic conductive films of ITO or the like; optical integrated circuits/optical switching elements/optical waveguides constituted with glass and crystalline materials; end faces of optical fibers; optical single crystals such as scintillators; solid laser single crystals; sapphire substrates for blue laser LED; semiconductor single crystals of SiC, GaP, GaAs, and the like; glass substrates for magnetic discs; and magnetic heads.

### <Manufacturing method and the like>

A method for producing a component of the present embodiment includes a component producing step of obtaining a component by using a base substrate (polished member) polished by the polishing method of the present embodiment. A component of the present embodiment is a component obtained by the method of producing a component of the present embodiment. The component of the present embodiment is not particularly limited, and may be an electronic component (for example, a semiconductor component such as a semiconductor package), may be a wafer (for example, a semiconductor wafer), and may be a chip (for example, a semiconductor chip). As an embodiment of the method for producing a component of the present embodiment, in a method for producing an electronic component of the present embodiment, an electronic component is obtained by using a base substrate polished by the polishing method of the present embodiment. As an embodiment of the method for producing a component of the present embodiment, in a method for producing a semiconductor component of the present embodiment, a semiconductor component (for example, a semiconductor package) is obtained by using a base substrate polished by the polishing method of the present embodiment. The method for producing a component of the present embodiment may include a polishing step of polishing a base substrate by the polishing method of the present embodiment before the component producing step.

The method for producing a component of the present embodiment may include, as an embodiment of the component producing step, an individually dividing step of dividing a base substrate (polished member) polished by the polishing method of the present embodiment into individual pieces. The individually dividing step may be, for example, a step of dicing a wafer (for example, a semiconductor wafer) polished by the polishing method of the present embodiment to obtain chips (for example, semiconductor chips). As an embodiment of the method for producing a component of the present embodiment, the method for producing an electronic component of the present embodiment may include a step of obtaining an electronic component (for example, a semiconductor component) by individually dividing a base substrate polished by the polishing method of the present embodiment into individual pieces. As an embodiment of the method for producing a component of the present embodiment, the method for producing a semiconductor component of the present embodiment may include a step of obtaining a semiconductor component (for example, a semiconductor package) by individually dividing a base substrate polished by the polishing method of the present embodiment into individual pieces.

The method for producing a component of the present embodiment may include, as an embodiment of the component producing step, a connecting step of connecting (for example, electrically connecting) a base substrate (polished member) polished by the polishing method of the present embodiment to another body to be connected. The body to be connected that is connected to the base substrate polished by the polishing method of the present embodiment is not particularly limited, and may be a base substrate polished by the polishing method of the present embodiment, and may be a body to be connected different from the base substrate polished by the polishing method of the present embodiment. In the connecting step, the base substrate and the body to be connected may be directly connected to each other (connected in a state where the base substrate and the body to be connected are in contact with each other), and the base substrate and the body to be connected may be connected via another member (such as a conductive member). The connecting step can be performed before the individually dividing step, after the individually dividing step, or before and after the individually dividing step.

The connecting step may be a step of connecting a polished surface of a base substrate polished by the polishing method of the present embodiment to a body to be connected, and may be a step of connecting a connection surface of a base substrate polished by the polishing method of the present embodiment to a connection surface of a body to be connected. The connection surface of the base substrate may be a polished surface that is polished by the polishing method of the present embodiment. A connection body having the base substrate and the body to be connected can be obtained by the connecting step. In the connecting step, in a case where the connection surface of the base substrate has a metal portion, the body to be connected may be connected to the metal portion. In the connecting step, in a case where the connection surface of the base substrate has a metal portion and the connection surface of the body to be connected has a metal portion, the metal portions may be connected to each other. The metal portion may contain copper.

A device of the present embodiment (for example, an electronic device such as a semiconductor device) has at least one selected from the group consisting of the base substrate polished by the polishing method of the present embodiment and the component of the present embodiment.

### Examples

Hereinafter, the present disclosure will be further specifically described by means of Examples; however, the present disclosure is not limited to these Examples.

### <Preparation of cerium oxide powder>

40 kg of cerium carbonate hydrate was divided and placed in ten of alumina containers, respectively, and fired at 830°C for 2 hours in air to obtain 20 kg of yellowish-white powder in total. The phase identification of this powder was performed by an X-ray diffraction method, and it was confirmed that this powder contained polycrystalline cerium oxide. The particle diameter of the powder obtained by firing was observed with a SEM and was found to be in a range of 20 to 100 µm. Next, 20 kg of the cerium oxide powder was subjected to dry pulverization using a jet mill to obtain a cerium oxide powder A (powder providing Abrasive grains A described below). The specific surface area of the cerium oxide powder A after pulverization was 9.4 m²/g. The measurement of the specific surface area was performed by the BET method.

### <Preparation of slurry>

15.0 kg of the cerium oxide powder obtained above and 84.5 kg of deionized water were placed in a container and mixed. Next, 0.5 kg of 1 M (mol/L, about 6% by mass) of acetic acid was added and then stirred for 10 minutes, thereby obtaining a cerium oxide mixed liquid. This cerium oxide mixed liquid was sent to another container over 30 minutes. Meanwhile, in the sending pipe, the cerium oxide mixed liquid was irradiated with ultrasonic wave at an ultrasonic wave frequency of 400 kHz.

A 800 g ± 8 g portion of the cerium oxide mixed liquid conveyed with the ultrasonic irradiation was divided into each of four 1000 mL polyethylene containers. The cerium oxide mixed liquid in each container was subjected to centrifugal separation for 20 minutes under conditions with an outer peripheral centrifugal force of 500 G. After centrifugal separation, the supernatant fraction in the container was collected to obtain a slurry. The slurry contained about 10.0% by mass of cerium oxide particles (abrasive grains) based on the total mass.

The slurry was diluted with pure water so that the content of the abrasive grains was 0.25% by mass based on the total mass, thereby obtaining a sample for particle diameter measurement. For this sample, the average particle diameter of the abrasive grains was measured using a laser diffraction/scattering particle size distribution measuring device (manufactured by MicrotracBEL Corp., trade name: Microtrac MT3300EXII), and as a result, the average particle diameter thereof was 140 nm.

### <Preparation of polishing liquid for CMP>

The aforementioned slurry, each additive, and deionized water were mixed in the following procedure to obtain a polishing liquid having the composition (balance: deionized water) of each table below. In the table, "THEED" means 2,2',2",2'"-ethylenedinitrilotetraethanol, and "EDTP" means 1,1',1",1‴-ethylenedinitrilotetra-2-propanol. Each polishing liquid contains acetic acid in a content corresponding to each of the contents of the abrasive grains, as acetic acid mixed at the time of preparation of the aforementioned slurry.

Specifically, each additive was dissolved in deionized water to obtain an additive solution. Next, the aforementioned slurry and the additive solution were mixed in equal amounts and then stirred for 10 minutes to obtain a stock solution for a polishing liquid in a concentrated state containing 5.0% by mass of abrasive grains based on the total mass. The stock solution for a polishing liquid contains the abrasive grains and the additive at 20-fold amounts with respect to 0.25% by mass of the content of the abrasive grains of the final polishing liquid, and contains the abrasive grains and the additive at 5-fold amounts with respect to 1.00% by mass of the content of the abrasive grains of the final polishing liquid.

Further, the stock solution for a polishing liquid was diluted 20-fold with deionized water to obtain each polishing liquid of Examples A1 and A4 and Comparative Example A1. Furthermore, the stock solution for a polishing liquid was diluted 5-fold with deionized water to obtain each polishing liquid of Examples A2, A3, and B1 to B6 and Comparative Examples A2, A3, and B1. For the polishing liquid of each of Examples, the average particle diameter of the abrasive grains in a case where the content of the abrasive grains was 0.25% by mass (for the polishing liquid having a content of the abrasive grains of 1.00% by mass, in a case where the content of the abrasive grains was adjusted to 0.25% by mass) based on the total mass was equivalent to the average particle diameter of the abrasive grains in the aforementioned slurry.

### <Zeta potential measurement>

An adequate amount of the polishing liquid was charged into trade name "DelsaNano C" manufactured by Beckman Coulter, Inc. and measurement was performed twice at 25°C. The average value of the displayed zeta potentials was obtained as the zeta potential. The zeta potential of the abrasive grains in each of Examples and Comparative Examples was positive.

### <pH measurement>

### (pH of polishing liquid)

The pH of the polishing liquid was measured under the following conditions. The results are shown in each table.
Measurement temperature: 25°C
Measuring apparatus: trade name: Model (D-71) manufactured by HORIBA, Ltd.
Measurement method: calibrating the pH meter by three points using a pH standard solution (pH: 4.01) of a phthalate, a pH standard solution (pH: 6.86) of a neutral phosphate, and a pH standard solution (pH: 9.18) of a borate as pH standard solutions, then putting an electrode of the pH meter in the polishing liquid, and measuring the pH with the above-described measuring apparatus at the time after 2 min or more elapsed and the pH became stable.

### <Evaluation of polishing properties>

### (Preparation of wafer for evaluation)

As a blanket wafer (BKW), a φ200 mm wafer with no pattern having a silicon oxide film (SiO₂, initial film thickness: 1000 nm) on a surface thereof was prepared.

As a pattern wafer (PTW), a test patterned wafer (in-house product, φ200 mm) of a silicon oxide film (initial film thickness: 7200 nm) having concavo-convex patterns on a surface thereof was prepared. The convex portion (Line portion) has an initial step height of 6000 nm higher than the concave portion (Space portion), and the convex portion is intended for polishing evaluation of protrusions having a high step height and a low density by etching-back. The pattern wafer has a plurality of die units of 26 mm × 26 mm, each die unit has a plurality (four) of unit areas of 13 mm × 13 mm, and as one of the unit areas, a region with a parallel line pattern in which Line/Space (L/S) is 30 µm/570 µm (density of convex portion: 5%) was evaluated.

### (Polishing procedure)

The aforementioned wafer for evaluation was polished using a polishing apparatus (manufactured by Applied Materials, Inc., trade name: Mirra3400). The aforementioned wafer for evaluation was set in a holder having an adsorption pad for attachment of the base substrate. A polishing pad made of a porous urethane resin (K-groove, manufactured by DuPont (Dow), Model No.: IC-1010) was attached to a polishing platen having a diameter of 500 mm.

The aforementioned holder was placed on the polishing pad with the surface to be polished of the aforementioned wafer for evaluation facing downward. The inner tube pressure, the retainer ring pressure, and the membrane pressure were set to 14 kPa, 21 kPa, and 14 kPa, respectively.

Then, while adding dropwise the aforementioned polishing liquid onto the polishing pad attached to the aforementioned polishing platen at a flow rate of 200 mL/min, the polishing platen and the wafer for evaluation were rotated at 93 min⁻¹ and 87 min⁻¹, respectively, for polishing the surface to be polished. In the blanket wafer, polishing was performed for 30 seconds. In the pattern wafer, polishing was performed for 60 seconds as a polishing time when the convex portion remained after polishing. Subsequently, the polished wafer for evaluation was thoroughly washed with pure water using a PVA brush (polyvinyl alcohol brush) and then dried.

### (Evaluation of polishing rate)

A light interference type film thickness measuring apparatus (manufactured by Nanometrics Japan Ltd., trade name: AFT-5100) was used to measure a change amount in film thickness of the film to be polished before and after polishing as described below, thereby obtaining a polishing rate. The results are shown in each table.

In the blanket wafer, the change amount in film thickness was measured at a total of 41 (20 points on both sides of the center point) measuring points, including the center point of the wafer and respective points at 5 mm intervals from the center point in the diameter direction (the next measuring point from the measuring point 95 mm from the center was at a location 97 mm from the center). The change amount in film thickness during a polishing time of 30 seconds was measured at these 41 points, and an average value thereof was obtained as the polishing rate for the blanket wafer.

In the pattern wafer, in the central die unit (26 mm × 26 mm) of the pattern wafer, the change amount in film thickness at one place of the convex portion (30 µm width line) at the central part of the pattern with L/S = 30 µm/570 µm of one unit area (13 mm × 13 mm) was measured to obtain the polishing rate for the pattern wafer.

**[Table 1]**

| | | Example | | | | Comparative Example | | |
|---|---|---|---|---|---|---|---|---|
| | | A1 | A2 | A3 | A4 | A1 | A2 | A3 |
| Abrasive grains | Content [mass%] | 0.25 | 1.00 | 1.00 | 0.25 | 0.25 | 1.00 | 1.00 |
| 4-Pyrone-based compound | Content [mass%] | 0.034 | 0.100 | 0.200 | 0.034 | 0.034 | 0.100 | 0.200 |
| Nitrogen-containing hydroxyalkyl compound | Type | THEED | THEED | THEED | EDTP | - | - | - |
| | Content [mass%] | 0.03 | 0.02 | 0.02 | 0.05 | | | |
| Propionic acid | Content [mass%] | 0.045 | - | - | 0.045 | 0.045 | - | - |
| pH | | 4.60 | 7.30 | 7.30 | 4.60 | 3.65 | 4.40 | 4.40 |
| Polishing rate [nm/min] | BKW | 460 | 687 | 300 | 493 | 444 | 422 | 395 |
| | PTW | 2123 | 3465 | 3465 | 2116 | 580 | 1703 | 1790 |

**[Table 2]**

| | | Example | | | | | | Comparative Example |
|---|---|---|---|---|---|---|---|---|
| | | B1 | B2 | B3 | B4 | B5 | B6 | B1 |
| Abrasive grains | Content [mass%] | 1.00 | 1.00 | 1.00 | 1.00 | 1.00 | 1.00 | 1.00 |
| Picolinic acid | Content [mass%] | 0.200 | 0.200 | 0.200 | 0.200 | 0.200 | 0.200 | 0.200 |
| Nitrogen-containing hydroxyalkyl compound | Type | THEED | THEED | THEED | THEED | EDTP | EDTP | - |
| | Content [mass%] | 0.01 | 0.05 | 0.13 | 0.22 | 0.02 | 0.03 | |
| pH | | 4.00 | 4.60 | 5.10 | 5.60 | 4.10 | 4.30 | 3.67 |
| Polishing rate [nm/min] | BKW | 532 | 516 | 500 | 494 | 543 | 455 | 554 |
| | PTW | 2432 | 3185 | 3000 | 2868 | 2440 | 2802 | 2049 |

### Reference Signs List

10: ILD film, 20: wiring, 30: silicon oxide film, 40: contact plug, 100, 100a: base substrate, D: step height.

## Claims

1. A polishing liquid for CMP, comprising:
abrasive grains; an additive; and water, wherein
the abrasive grains include cerium-based particles, and
the additive includes (A1) a 4-pyrone-based compound represented by General Formula (1) below and (B) a compound having two or more nitrogen atoms to which a hydroxyalkyl group is bonded: 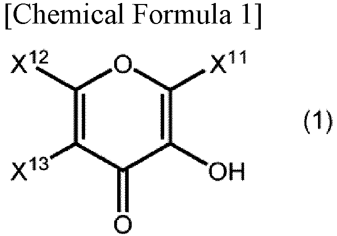 [in the formula, X¹¹, X¹², and X¹³ are each independently a hydrogen atom or a monovalent substituent.]

2. The polishing liquid for CMP according to claim 1, wherein the component (A1) includes at least one selected from the group consisting of 3-hydroxy-2-methyl-4-pyrone, 5-hydroxy-2-(hydroxymethyl)-4-pyrone, and 2-ethyl-3-hydroxy-4-pyrone.

3. The polishing liquid for CMP according to claim 1, wherein a content of the component (A1) is 0.001 to 5% by mass.

4. The polishing liquid for CMP according to claim 1, wherein the component (B) includes an ethylenedinitrilotetraethanol.

5. The polishing liquid for CMP according to claim 1, wherein the component (B) includes an ethylenedinitrilotetrapropanol.

6. The polishing liquid for CMP according to claim 1, wherein a content of the component (B) is 0.001 to 5% by mass.

7. The polishing liquid for CMP according to claim 1, wherein the additive further includes a saturated monocarboxylic acid.

8. The polishing liquid for CMP according to claim 1, wherein a pH is 8.0 or less.

9. A polishing liquid for CMP, comprising:
abrasive grains; an additive; and water, wherein
the abrasive grains include cerium-based particles, and
the additive includes (A2) picolinic acid and (B) a compound having two or more nitrogen atoms to which a hydroxyalkyl group is bonded.

10. The polishing liquid for CMP according to claim 9, wherein a content of the component (A2) is 0.001 to 5% by mass.

11. The polishing liquid for CMP according to claim 9, wherein the component (B) includes an ethylenedinitrilotetraethanol.

12. The polishing liquid for CMP according to claim 9, wherein the component (B) includes an ethylenedinitrilotetrapropanol.

13. The polishing liquid for CMP according to claim 9, wherein a content of the component (B) is 0.001 to 5% by mass.

14. The polishing liquid for CMP according to claim 9, wherein a pH is 8.0 or less.

15. A polishing liquid set for CMP, comprising:
constituent components of the polishing liquid for CMP according to any one of claims 1 to 14, separately stored as a first liquid and a second liquid, wherein
the first liquid contains the abrasive grains and water, and
the second liquid contains at least one of the additives and water.

16. A polishing method comprising a step of polishing a surface to be polished by using the polishing liquid for CMP according to any one of claims 1 to 14.

17. The polishing method according to claim 16, wherein the surface to be polished contains silicon oxide.

18. A polishing method comprising a step of polishing a surface to be polished by using a polishing liquid for CMP obtained by mixing the first liquid and the second liquid of the polishing liquid set for CMP according to claim 15.

19. The polishing method according to claim 18, wherein the surface to be polished contains silicon oxide.
